# DEMANDE DE BREVET EUROPEEN

(11) **EP 4 757 179 A1**
(43) Date de publication de la demande: **10.06.2026**
(21) Numéro de dépôt: 25219048.3
(22) Date de dépôt: 27.11.2025
(51) Int. Cl.: H03H 3/02, H03H 9/17, H10N 30/00

(54) **PROCÉDÉ DE FABRICATION D'UN DISPOSITIF ÉLECTRONIQUE**

(30) Priorité: 06.12.2024 FR 2413578
(71) Demandeur: Commissariat à l'Energie Atomique et aux Energies Alternatives, 75015 Paris (FR)
(72) Inventeur: BOUSQUET, Marie, 38054 GRENOBLE Cedex 9 (FR); REINHARDT, Alexandre, 38054 GRENOBLE Cedex 9 (FR); PERREAU, Pierre, 38054 GRENOBLE Cedex 9 (FR); BALLERAND, Stéphane, 38054 GRENOBLE Cedex 9 (FR); DENIZART, Joey, 38054 GRENOBLE Cedex 9 (FR)
(74) Mandataire: Germain Maureau

(57) **Abrégé**

L'invention concerne un procédé de fabrication (P2) d'un dispositif électronique (100) résonant comprenant une étape de mise à disposition (E10) d'un empilement primaire (30) comprenant : une étape de fourniture (E1) d'un empilement initial (10) comprenant un substrat initial (11) présentant une face avant (Fav) comprenant une zone centrale (Zc) et une zone de détourage périphérique (Zdp), et une couche mince résonante (13) en matériau piézoélectrique ; et une étape de protection (E2), dans laquelle une couche mince de protection (17) est déposée sur l'empilement initial (10) et recouvrant la zone de détourage périphérique (Zdp); la couche mince de protection (17) étant en un matériau présentant une impédance acoustique supérieure à 20 MRayl pour des ondes longitudinales et/ou supérieure à 12 MRayl pour des ondes de cisaillement.

L'invention concerne également un dispositif électronique (100) résonant.

## Description

### Domaine technique de l'invention

La présente invention concerne les dispositifs microélectroniques comprenant au moins une couche mince résonante reportée sur un substrat.

Plus particulièrement, l'invention concerne un procédé de formation d'un empilement primaire comprenant une couche mince de matériau ferroélectrique, pyro-, ou piézoélectrique et un procédé de fabrication d'un dispositif électronique à partir d'un tel empilement primaire.

### Etat de la technique

On connaît de l'état de la technique différents procédés permettant de former une couche mince sur un substrat support. Il peut s'agir, par exemple, de techniques de dépôt par voie physique telles que l'épitaxie par jet moléculaire (« Molecular Beam Epitaxy » en anglais, ou MBE), la pulvérisation cathodique (« Plasma Sputtering » en anglais), ou le dépôt par ablation par laser pulsé (« Laser Pulsed Deposition » en anglais ou PLD), ou de techniques de dépôt par voie chimique comme par exemple le procédé sol-gel ou le dépôt chimique en phase vapeur à partir de précurseurs métalorganiques (« MetalOrganic Chemical Vapour Deposition » ou MOCVD en anglais), ou bien encore les techniques de transfert de couches telle que la technologie Smart Cut^{™} (« crystal ion slicing ») selon laquelle une couche mince est prélevée d'un substrat massif par fracture au niveau d'une zone fragile (ou plan de fragilisation) créée dans le substrat massif par implantation d'espèces légères (H, He par exemple).

Cette dernière méthode est particulièrement adaptée pour former une couche mince monocristalline d'un matériau piézoélectrique, qui est utilisée comme système résonant.

Ces couches minces résonantes peuvent par exemple être utilisées dans la fabrication de résonateurs ou de filtres passifs à ondes acoustiques de surface (en anglais « Surface Acoustic Wave » ou SAW), ou de volume (en anglais « Bulk Acoustic Wave » ou BAW) ou à ondes de Lamb (également appelé ondes de plaque). Ces dispositifs sont tout particulièrement employés dans les systèmes de communication sans fil, où ils permettent une ségrégation des nombreux signaux captés par les antennes d'un terminal de communication, et permettent ainsi d'assurer les niveaux de rapport signal à bruit requis par les normes de télécommunication en place.

Dans ces dispositifs, l'épaisseur de la couche mince résonante est un paramètre critique pour le bon fonctionnement du résonateur ou du filtre. En effet, la largeur de la bande passante du filtre est fonction de l'espacement relatif entre les fréquences de résonance et d'antirésonance des résonateurs qui le compose. Or cet écart est quantifié par un coefficient dit de couplage électromécanique (k²), qui par ailleurs quantifie la fraction d'énergie pouvant être convertie du domaine électrique au domaine mécanique, ou vice-versa, au sein d'un résonateur à chaque période d'oscillation. Ce coefficient dépend directement de la géométrie du résonateur, du type d'onde exploitée, mais également des propriétés piézoélectriques du matériau employé. La technologie Smart Cut^{™} est donc particulièrement adaptée pour la réalisation de ce genre de dispositifs car elle permet de contrôler finement l'épaisseur de la couche mince résonante. Cette technologie permet également d'obtenir des couches minces présentant différentes orientations (par exemple, X-, Y-, Y+36°-, Y+163°-, ou Z-cut), sous différentes tailles (de 75 à 300 mm). Le document US20220166398A1 décrit un procédé de fabrication de tels dispositifs.

Lors de la formation des substrats comportant cette couche mince résonante, une étape de détourage est mise en œuvre en bord de plaque, formant (pour les substrats en forme de disque), une couronne en périphérie dépourvue de couche mince résonante. Cette couronne périphérique est particulièrement utile pour les opérations de transfert des substrats, car elle permet leur préhension en périphérie par les équipements de fabrication.

Toutefois, dans la fabrication de certains dispositifs et notamment des résonateurs et filtres, une telle couronne périphérique sert aussi de point d'entrée pour des infiltrations en bord de plaque. Cela détériore par les bords, la plaque comprenant les dispositifs. De telles infiltrations se produisent généralement lors des étapes de report et de gravure, et notamment lors d'étapes de gravures chimiques (par exemple, les gravures à l'acide fluorhydrique). Cela est particulièrement dommageable dans la fabrication des résonateurs et filtres, car la gravure à l'acide fluorhydrique est souvent utilisée pour sa sélectivité vis-à-vis du matériau piézoélectrique. Il en résulte une dégradation substantielle des dispositifs en bord de plaque, ce qui limite les rendements de productions et augmente la quantité de rebus.

Par ailleurs, étant donné que la couche mince résonante piézoélectrique est une couche sensible dans ces dispositifs, toute couche entrant en contact avec cette dernière peut grever les performances des dispositifs. Il existe donc un besoin de trouver un moyen d'empêcher les dégradations en bord de plaque lors de la formation d'un empilement comprenant une couche mince résonante piézoélectrique, sans grever pour autant les performances de ladite couche mince résonante.

### Objet de l'invention

La présente invention a pour but de proposer une solution qui réponde à tout ou partie des problèmes précités.

Ce but peut être atteint grâce à la mise en œuvre d'un procédé de formation d'un empilement primaire pour la fabrication d'un dispositif électronique, le procédé de formation comprenant :
- une étape de fourniture, dans laquelle un empilement initial est fourni, ledit empilement initial comprenant :
   ∘ un substrat initial présentant une face avant, ladite face avant comprenant une zone centrale et une zone de détourage périphérique, la zone de détourage périphérique étant adjacente à un bord périphérique de la face avant d'une part, et entourant la zone centrale d'autre part ;
   ∘ une couche mince résonante en matériau piézoélectrique présentant une surface supérieure tournée vers le substrat initial et une surface inférieure opposée à la surface supérieure ; et
   ∘ une couche de liaison, interposée entre la zone centrale du substrat initial, et la surface supérieure de la couche mince résonante ;
- une étape de protection, dans laquelle une couche mince de protection est déposée sur l'empilement initial du côté de la surface inférieure de la couche mince résonante, ladite couche mince de protection recouvrant la zone de détourage périphérique; la couche mince de protection étant en un matériau présentant une impédance acoustique supérieure à 20 MRayl pour des ondes longitudinales et/ou supérieure à 12 MRayl pour des ondes de cisaillement, l'empilement primaire étant formé à l'issue de l'étape de protection.

Les dispositions précédemment décrites permettent de proposer un procédé permettant la formation d'un empilement primaire comprenant une couche mince de protection destinée à protéger la couche mince résonante lors d'étapes ultérieures du procédé, notamment en périphérie de la couche mince de protection.

Dans l'ensemble du texte et de manière générale, 1 MRayl = 106 kg/(m².s).

Le procédé de formation peut en outre présenter une ou plusieurs des caractéristiques suivantes, prises seules ou en combinaison.

Selon un mode de réalisation, lors de l'étape de protection, la couche mince de protection est déposée de sorte à recouvrir partiellement ou totalement la surface supérieure de la couche mince résonante, ainsi que la zone de détourage périphérique.

Ainsi, il est possible de protéger la couche mince résonante en une seule étape de procédé. Par ailleurs, réaliser le dépôt de la couche mince de protection sur l'intégralité de la surface apparente de l'empilement initial permet de simplifier le procédé de formation, ce qui réduit les coûts.

Selon un mode de réalisation, lors de l'étape de protection, le matériau de la couche mince de protection est choisi dans le groupe composé de AIN, Al₂O₃, HfN, HfO₂, SiₓN_{y}, Ta₂O₅, TiN, TaN, TiO₂, WO₃, ZnO, et ZrO₂.

Ainsi, le matériau choisi pour la couche mince de protection est particulièrement adapté pour protéger la couche mince résonante lors d'une étape de gravure par voie chimique et notamment avec de l'acide fluorhydrique.

Selon un mode de réalisation, lors de l'étape de fourniture, la couche mince résonante présente une épaisseur inférieure à 2 µm, et notamment inférieure à 1 µm.

De cette manière, l'empilement primaire est adapté pour la fabrication de filtres radiofréquences.

Selon un mode de réalisation, l'étape de fourniture comprend :
- la fourniture d'un substrat donneur comprenant une couche épaisse, le substrat donneur présentant une face principale du côté de la couche épaisse
- l'implantation d'espèces légères dans la couche épaisse pour y générer un plan de fragilisation et pour définir ainsi la couche mince résonnante entre le plan de fragilisation et la face principale du substrat donneur ;
- la mise en contact de la face principale du substrat donneur avec la face avant du substrat initial ;
- le détachement de la couche mince résonante au niveau du plan de fragilisation, par l'application d'un traitement thermique.

Les étapes précédemment décrites permettent de prélever une couche mince d'un substrat massif par fracture, par l'utilisation de la technologie Smart Cut^{™}, ce qui permet de former la couche mince résonante. Un mode de réalisation de la mise en œuvre de telles étapes est décrit dans le document US20230353115A1.

Selon un mode de réalisation, lors de l'étape de protection, la couche mince de protection est en nitrure de silicium, et présente une épaisseur inférieure ou égale à 100 nm.

De cette manière, il est possible de bénéficier de la protection contre la gravure par le matériau à forte impédance acoustique, et d'avoir une épaisseur de couche mince de protection suffisamment faible pour ne pas dégrader les performances du résonateur, notamment en termes de fréquence de résonnance, de coefficient de couplage et de facteur de qualité.

Selon un mode de réalisation, lors de l'étape de protection, la couche mince de protection est en nitrure d'aluminium, et présente une épaisseur inférieure ou égale à 50 nm.

De cette manière, il est possible de bénéficier de la protection contre la gravure par le matériau à forte impédance acoustique, et d'avoir une épaisseur de couche mince de protection suffisamment faible pour ne pas dégrader les performances du résonateur, notamment en termes de fréquence de résonnance, de coefficient de couplage et de facteur de qualité.

Selon un mode de réalisation, lors de l'étape de fourniture, l'empilement initial comprend des électrodes inférieures en contact électrique avec la surface inférieure de la couche mince résonante.

Ainsi, il est possible de reprendre un contact électrique au niveau de la couche mince résonante.

De manière générale, les électrodes inférieures sont en contact direct avec la couche mince résonante.

Le but de l'invention peut également être atteint grâce à la mise en oeuvre d'un procédé de fabrication d'un dispositif électronique résonant, le procédé de fabrication comprenant :
- une étape de mise à disposition, dans laquelle un empilement primaire obtenu par un procédé de formation tel que décrit précédemment, et un empilement récepteur sont mis à disposition, l'empilement récepteur présentant une face de réception ;
- une étape de dépôt de couche de collage, dans laquelle une couche de collage est déposée du côté de la surface inférieure de la couche mince résonante ;
- une étape de collage, dans laquelle la face de réception de l'empilement récepteur, et la couche de collage sont mis en contact intime, de manière à solidariser l'empilement primaire avec l'empilement récepteur ;
- une phase de retrait, dans laquelle le substrat initial et la couche de liaison sont retirés par voies mécanique et chimique ; et
- une étape de définition d'électrodes, dans laquelle des électrodes supérieures sont déposées sur la surface supérieure de la couche mince résonante, puis définies par photolithographie, gravure et retrait de résine, de sorte que les électrodes supérieures soient en contact électrique avec la couche mince résonante.

Les dispositions précédemment décrites permettent de fabriquer un dispositif électronique résonant dans lequel la couche mince de protection assure une protection contre la gravure humide et notamment l'acide fluorhydrique. Il est ainsi possible de limiter des endommagements de la couche mince résonante à proximité du bord périphérique, notamment par infiltration.

De manière surprenante, il a été constaté que la présence d'une couche mince de protection présentant une forte impédance acoustique permettait de protéger la couche mince résonante sans grever les performances en résonance de cette couche. Cela est particulièrement contre-intuitif dans la fabrication d'un dispositif électronique résonant, où la présence d'une couche de forte impédance acoustique à proximité de la couche mince résonante devrait à priori altérer ses performances.

Le procédé de fabrication peut en outre présenter une ou plusieurs des caractéristiques suivantes, prises seules ou en combinaison.

Selon un mode de réalisation, l'étape de dépôt de couche de collage comprend le dépôt et la réalisation de la couche de collage, par déposition puis planarisation de cette couche de collage du côté de la surface inférieure de la couche mince résonante.

Selon un mode de réalisation, la couche de collage comprend un oxyde métallique comme l'oxyde de silicium SiO₂, ou un polymère.

Selon un mode de réalisation, lors de l'étape de mise à disposition, l'empilement récepteur comprend une couche d'isolant acoustique, ladite couche d'isolant acoustique portant la face de réception de l'empilement récepteur.

Le procédé de fabrication est ainsi adapté pour la fabrication d'un résonateur à ondes acoustiques de volume.

Selon un mode de réalisation, la couche d'isolant acoustique est un miroir de Bragg.

Le procédé de fabrication est ainsi adapté pour la fabrication d'un résonateur à onde acoustiques de volume sur réflecteur.

Selon un mode de réalisation, la phase de gravure comprend :
- une première étape de gravure, dans laquelle le substrat initial est retiré par meulage puis par gravure chimique anisotrope ; et
- une deuxième étape de gravure, dans laquelle la couche de liaison est retirée par gravure chimique à l'acide fluorhydrique.

De manière avantageuse, le retrait du substrat initial est réalisé tout d'abord par meulage pour supprimer une plus grande quantité de matière, puis par gravure chimique sélective avec le matériau du substrat initial. Par ailleurs, la deuxième étape de gravure permet de retirer sélectivement la couche de liaison, généralement formé en dioxyde de silicium, sans endommager la couche mince résonante.

Le but de l'invention peut également être atteint grâce à la mise en œuvre d'un dispositif électronique résonant obtenu par un procédé de fabrication tel que décrit précédemment, le dispositif électronique résonant comprenant l'empilement successif d'au moins :
- un empilement récepteur ;
- une couche de collage ;
- une couche mince de protection comprenant un matériau isolant électrique ;
- des électrodes inférieures en contact direct avec la couche mince de protection ;
- une couche mince résonante en matériau piézoélectrique présentant une surface supérieure et une surface inférieure opposées, la surface inférieure étant en contact électrique avec les électrodes inférieures ;
- des électrodes supérieures en contact électriques avec la surface supérieure de la couche mince résonante ;

Dans ce dispositif électronique résonant, la couche mince de protection présente une impédance acoustique supérieure à 20 MRayl pour des ondes longitudinales et/ou supérieure à 12 MRayl pour des ondes de cisaillement.

Les dispositions précédemment décrites permettent de proposer un dispositif électronique résonant présentant peu de défauts à proximité du bord périphérique.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
La figure 1 est une représentation schématique d'une étape de fourniture selon un mode de réalisation particulier de l'invention.
La figure 2 est une représentation schématique du procédé de formation et d'une étape de dépôt de couche de collage selon un mode de réalisation particulier de l'invention.
La figure 3 est une représentation schématique du procédé de formation et d'une phase de retrait selon un mode de réalisation particulier de l'invention.
La figure 4 est une représentation schématique de certaines étapes du procédé de fabrication.
La figure 5 est une représentation schématique du procédé de formation et du procédé de fabrication selon un mode de réalisation particulier de l'invention.

### Description détaillée

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

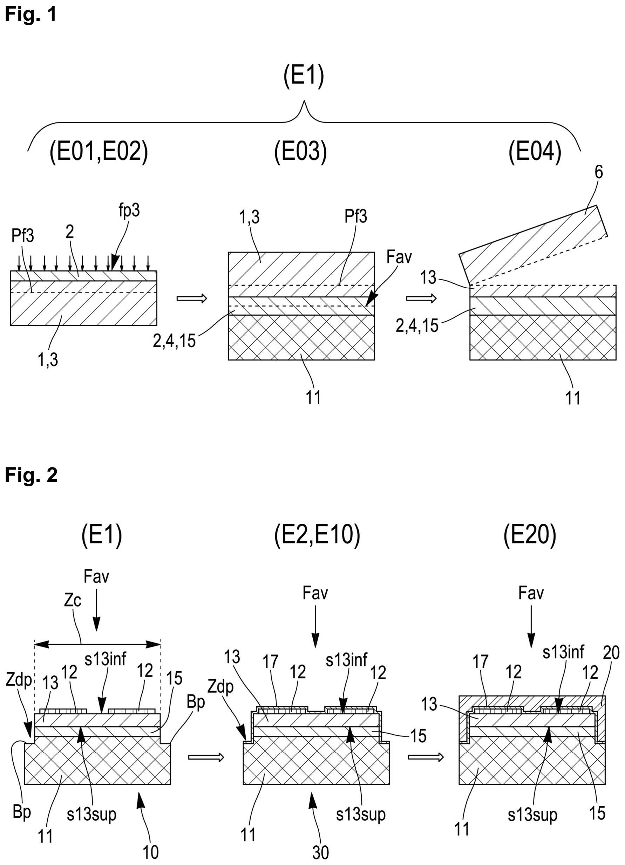

Comme on peut le voir sur les figures 1 à 5, l'invention concerne procédé de fabrication P2 d'un dispositif électronique 100 résonant comprenant les étapes d'un procédé de formation P1 d'un empilement primaire 30 pour la fabrication d'un dispositif électronique 100.

Le procédé de formation P1 comprenant tout d'abord une étape de fourniture E1, dans laquelle un empilement initial 10 est fourni. Cet empilement initial 10 comprend notamment : un substrat initial 11 présentant une face avant notée « Fav », une couche mince résonante 13 en matériau piézoélectrique, et une couche de liaison 15, interposée entre le substrat inital 11 et la couche mince résonante 13.

La figure 1 illustre un mode de réalisation de cette étape de fourniture E1, comprenant une succession de sous étapes permettant à aboutir à la fourniture de l'empilement initial 10, connu sous le nom SmartCut^{™}. Sommairement, ce mode de réalisation peut comprendre tout d'abord la fourniture E01 d'un substrat donneur 1. Ce substrat donneur 1 comprend une couche épaisse 3 (présentant une épaisseur généralement supérieure à 10 µm), et optionnellement une couche de liaison primaire 2 disposée sur la couche épaisse 3. Le substrat donneur 1 présente ainsi une face principale fp3 du côté de la couche épaisse 3, et notamment du côté de la couche de liaison primaire 2.

Une étape d'implantation E02 peut ensuite être mise en œuvre, dans laquelle des espèces chimiques légères sont implantées dans la couche épaisse 3 pour y générer un plan de fragilisation Pf3, et pour définir ainsi la couche mince résonante 13 entre le plan de fragilisation Pf3 et la face principale fp3 du substrat donneur 1. Il est donc bien compris que ce plan de fragilisation Pf3 délimitera ultérieurement la couche mince résonante 13 avec la face principale fp3.

Une étape de mise en contact E03 est ensuite mise en œuvre par la mise en contact de la face principale fp3 du substrat donneur 1 avec la face avant Fav du substrat initial 11. Comme précédemment, il peut être avantageux que la face avant Fav du substrat initial 11 soit formée sur une couche de liaison secondaire 4. Un collage est ainsi réalisé entre la face principale fp3 et la face avant Fav par l'intermédiaire des couches de liaison primaire et secondaire 2, 4. Ces couches de liaisons primaire et secondaire 2, 4 forment ainsi une unique couche de liaison 15.

Enfin, une étape de détachage E04 peut être mise en œuvre. Lors de cette étape, la couche mince résonante 13 est formée par un détachement d'une partie 6 de la couche épaisse 3 au niveau du plan de fragilisation Pf3, par l'application par exemple d'un traitement thermique. Il est donc bien compris que la couche mince résonante 13 est la partie de la couche épaisse 3 qui reste attachée à la couche de liaison secondaire 4 suite au détachement de la partie 6 de la couche épaisse 3.

Une telle variante de l'étape de fourniture E1 est avantageusement mise en oeuvre pour former une couche mince résonante 13 monocristalline et d'épaisseur typiquement inférieure à 1 µm. Ainsi, le procédé de formation P1 est adapté à la fabrication de dispositifs optiques ou acoustiques. En particulier, le procédé de formation P1 est adapté à la fabrication de résonateurs ou de filtres acoustiques, comme les résonateurs à ondes acoustiques de surface (ou SAW, pour Surface Acoustic Wave selon la terminologie anglo-saxonne consacrée), les résonateurs à ondes de volume (ou BAW, pour Bulk Acoustic Wave selon la terminologie anglo-saxonne consacrée), ou encore les résonateurs à ondes de Lamb.

Quelle que soit la variante mise en oeuvre choisie, il en résulte la formation de l'empilement initial 10 qui comprend
- le substrat initial 11, dans lequel la face avant Fav comprend une zone centrale Zc et une zone de détourage périphérique Zdp, la zone de détourage périphérique Zdp étant adjacente à un bord périphérique Bp de la face avant Fav d'une part, et entourant la zone centrale Zc d'autre part ;
- la couche mince résonante 13 présentant une surface supérieure s13sup tournée vers le substrat initial 11 et une surface inférieure s13inf opposée à la surface supérieure s13sup ; et
- la couche de liaison 15, interposée entre la zone centrale Zc du substrat initial 11, et la surface supérieure s13sup de la couche mince résonante 13.

Comme cela est illustré sur la figure 2, afin de proposer un empilement initial 10 adapté pour la fabrication de dispositifs électronique 100 résonants, l'empilement initial 10 peut comprendre des électrodes inférieures 12 en contact électrique avec la surface inférieure s13inf de la couche mince résonante 13. De manière générale, les électrodes inférieures 12 sont en contact direct avec la couche mince résonante 13. Ainsi, il est possible de reprendre un contact électrique au niveau de la couche mince résonante 13. Par ailleurs, il est généralement prévu que la couche mince résonante 13 présente une épaisseur inférieure à 2 µm, et notamment inférieure à 1 µm. De cette manière, l'empilement primaire 30 est adapté pour la fabrication de filtres radiofréquence RF.

Le procédé de formation comprend ensuite une étape de protection E2, dans laquelle une couche mince de protection 17 est déposée sur l'empilement initial 10 du côté de la surface inférieure s13inf de la couche mince résonante 13. Cette couche mince de protection 17 recouvre la zone de détourage périphérique Zdp et au moins une partie de la surface supérieure.

Comme cela est illustré sur la figure 2, lors de l'étape de protection E2, la couche mince de protection 17 est déposée de sorte à recouvrir partiellement ou totalement la surface supérieure s13sup de la couche mince résonante 13, ainsi que la zone de détourage périphérique Zdp. Ainsi, il est possible de protéger la couche mince résonante 13 en une seule étape de procédé. Par ailleurs, réaliser le dépôt de la couche mince de protection 17 sur l'intégralité de la surface apparente de l'empilement initial 10 permet de simplifier le procédé de formation, ce qui réduit les coûts.

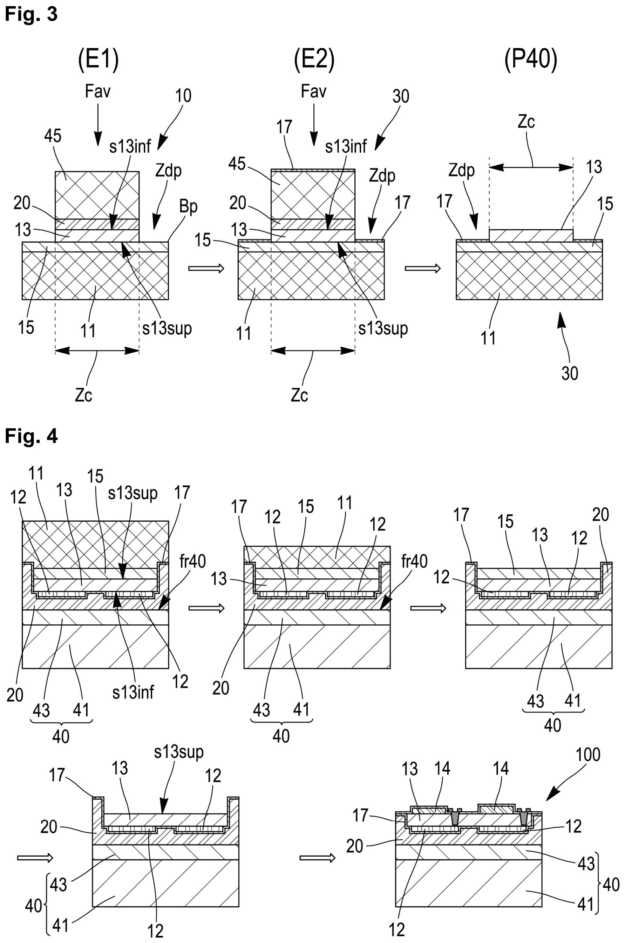

Sur le mode de réalisation de la figure 3, la couche mince de protection 17 est déposée du côté de la face avant Fav, et recouvre la zone de détourage périphérique Zdp. Elle recouvre le support temporaire 45 disposé en face avant Fav, ainsi que la surface inférieure s13inf et une couche de collage 20 interposées entre le support temporaire 45 et la surface inférieure s13inf. Il est alors possible de mettre en œuvre une phase de gravure P40 (qui sera décrite plus loin), pour retirer le support temporaire 45 et la couche de collage 20, formant ainsi l'empilement primaire 30.

La couche mince de protection 17 est en un matériau présentant une impédance acoustique supérieure à 20 MRayl pour des ondes longitudinales et/ou supérieure à 12 MRayl pour des ondes de cisaillement. Dans l'ensemble du texte et de manière générale, 1 MRayl = 106 kg/m².s. Par exemple le matériau de la couche mince de protection 17 est choisi dans le groupe composé du nitrure d'aluminium AIN, l'oxyde d'aluminium Al₂O₃, le nitrure d'hafnium HfN, le dioxyde d'hafnium HfO₂, le nitrure de silicium SiₓN_{y}, le pentoxyde de tantale Ta₂O₅, le nitrure de titane TiN, le nitrure de tantale TaN, le dioxyde de titane TiO₂, le trioxyde de tungstène WO₃, l'oxyde de zinc ZnO, et le dioxyde de zirconium ZrO₂. Ainsi, le matériau choisi pour la couche mince de protection 17 est particulièrement adapté pour protéger la couche mince résonante 13 lors d'une étape de gravure par acide fluorhydrique.

Selon une première variante, la couche mince de protection 17 peut être en nitrure de silicium SiₓN_{y}, et peut présenter une épaisseur inférieure ou égale à 100 nm. De cette manière, il est possible de bénéficier de la protection contre la gravure par le matériau à forte impédance acoustique, et d'avoir une épaisseur de couche mince de protection 17 suffisamment faible pour ne pas dégrader les performances du résonateur, notamment en termes de fréquence de résonnance, de coefficient de couplage et de facteur de qualité.

Selon une deuxième variante, la couche mince de protection 17 peut être en nitrure d'aluminium AIN, et peut présenter une épaisseur inférieure ou égale à 50 nm. De cette manière, il est possible de bénéficier de la protection contre la gravure par le matériau à forte impédance acoustique, et d'avoir une épaisseur de couche mince de protection 17 suffisamment faible pour ne pas dégrader les performances du résonateur, notamment en termes de fréquence de résonnance, de coefficient de couplage et de facteur de qualité.

Il résulte de ce procédé de formation P1, la formation d'un empilement primaire 30, obtenu à l'issue de l'étape de protection E2.

L'ensemble des dispositions précédemment décrites permettent de proposer un procédé permettant la formation d'un empilement primaire 30 comprenant une couche mince de protection 17 destinée à protéger la couche mince résonante 13 lors d'étapes ultérieures du procédé, notamment en périphérie de la couche mince de protection 17.

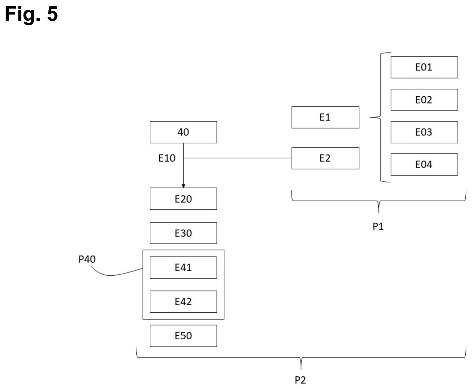

Le procédé de fabrication P2 d'un dispositif électronique 100 résonant, objet de l'invention, est illustré sur la figure 5.

Le procédé de fabrication P2 comprend tout d'abord une étape de mise à disposition E10, dans laquelle un empilement primaire 30 obtenu par le procédé de formation P1, et un empilement récepteur 40 sont mis à disposition. Il est donc possible que les étapes du procédé de formation P1 tel que décrit précédemment soient incluses dans le procédé de fabrication P2. L'empilement récepteur 40 présente une face de réception fr40.

Lors de l'étape de mise à disposition E10, l'empilement récepteur 40 comprend généralement une couche d'isolant acoustique 43, ladite couche d'isolant acoustique 43 portant la face de réception fr40 de l'empilement récepteur 40. Le procédé de fabrication P2 est ainsi adapté pour la fabrication d'un résonateur à ondes acoustiques de volume. Plus précisément, cette couche d'isolant acoustique 43 peut être un miroir de Bragg. Le procédé de fabrication P2 est ainsi adapté pour la fabrication d'un résonateur à onde acoustiques de volume sur réflecteur.

Comme cela est illustré sur la figure 3, une étape de dépôt de couche de collage E20 est mise en œuvre, dans laquelle une couche de collage 20 est déposée du côté de la surface inférieure s13inf de la couche mince résonante 13. Par exemple, cette couche de collage 20 peut comprendre un oxyde métallique comme l'oxyde de silicium SiO2, ou un polymère.

Ensuite, et comme illustré sur la figure 3, une étape de collage E30 est mise en œuvre, dans laquelle la face de réception fr40 de l'empilement récepteur 40, et la couche de collage 20 sont mis en contact intime, de manière à solidariser l'empilement primaire 30 avec l'empilement récepteur 40. Comme on le voit sur la figure, lors de cette étape de collage E30, l'empilement primaire 30 est retourné vers l'empilement récepteur 40, avec la couche de collage 20 disposée entre les deux empilements 30, 40. Cela se traduit notamment par un inversement de la position des surfaces inférieures s13inf et supérieures s13sup de la couche mince résonante 13 sur les figures.

Le procédé de fabrication P2 comprend ensuite une phase de retrait P40, dont un mode de réalisation est illustré sur la figure 4. Lors de cette phase de retrait P40, le substrat initial 11 et la couche de liaison 15 sont retirés par voies mécaniques et chimiques.

Par exemple, la phase de gravure P40 peut comprendre:
- une première étape de gravure E41, dans laquelle le substrat initial 11 est retiré par meulage puis par gravure chimique anisotrope ; et
- une deuxième étape de gravure E42, dans laquelle la couche de liaison 15 est retirée par gravure chimique à l'acide fluorhydrique.

De manière avantageuse, le retrait du substrat initial 11 est réalisé tout d'abord par meulage pour supprimer une plus grande quantité de matière, puis par gravure chimique sélective avec le matériau du substrat initial 11. Par ailleurs, la deuxième étape de gravure E42 permet de retirer sélectivement la couche de liaison 15, généralement formé en dioxyde de silicium, sans endommager la couche mince résonante 13.

Enfin, une étape de définition d'électrodes E50 est mise en œuvre, dans laquelle des électrodes supérieures 14 sont déposées sur la surface supérieure s13sup de la couche mince résonante 13, puis définies par photolithographie, gravure et retrait de résine, de sorte que les électrodes supérieures 14 soient en contact électrique avec la couche mince résonante 13.

L'ensemble des dispositions précédemment décrites permettent de fabriquer un dispositif électronique 100 résonnant dans lequel la couche mince de protection 17 assure une protection contre la gravure et notamment l'acide fluorhydrique généralement utilisé lors de la phase de gravure P40. Il est ainsi possible de limiter des endommagements de la couche mince résonante 13 à proximité du bord périphérique Bp, notamment par infiltration.

De manière surprenante, il a été constaté que la présence d'une couche mince de protection 17 présentant une forte impédance acoustique permettait de protéger la couche mince résonante 13 sans grever les performances en résonance de cette couche. Cela est particulièrement contre-intuitif dans la fabrication d'un dispositif électronique 100 résonant, où la présence d'une couche de forte impédance acoustique à proximité de la couche mince résonante 13 devrait à priori altérer ses performances.

L'invention concerne également un dispositif électronique 100 résonant obtenu par le procédé de fabrication P2. Ce dispositif électronique 100 résonant comprend l'empilement successif d'au moins :
- un empilement récepteur 40 ;
- une couche de collage 20 ;
- une couche mince de protection 17 comprenant un matériau isolant électrique ;
- des électrodes inférieures 12 en contact direct avec la couche mince de protection 17 ;
- une couche mince résonante 13 en matériau piézoélectrique présentant une surface supérieure s13sup et une surface inférieure s13inf opposées, la surface inférieure s13inf étant en contact électrique avec les électrodes inférieures 12 ; et
- des électrodes supérieures 14 en contact électriques avec la surface supérieure s13sup de la couche mince résonante 13 ;

Dans ce dispositif électronique 100 résonant, le matériau de la couche mince de protection 17 présente une impédance acoustique supérieure à 20 MRayl pour des ondes longitudinales et/ou supérieure à 12 MRayl pour des ondes de cisaillement. Les dispositions précédemment décrites permettent de proposer un dispositif électronique 100 résonant présentant peu de défauts à proximité du bord périphérique Bp.

## Revendications

1. Procédé de fabrication (P2) d'un dispositif électronique (100) résonant, le procédé de fabrication (P2) comprenant les étapes successives suivantes :
- une étape de mise à disposition (E10), dans laquelle un empilement primaire (30) et un empilement récepteur (40) sont mis à disposition, l'empilement récepteur (40) présentant une face de réception (fr40) ; l'empilement primaire (30) étant obtenu par les étapes suivantes :
• une étape de fourniture (E1), dans laquelle un empilement initial (10) est fourni, ledit empilement initial (10) comprenant :
- un substrat initial (11) présentant une face avant (Fav), ladite face avant (Fav) comprenant une zone centrale (Zc) et une zone de détourage périphérique (Zdp), la zone de détourage périphérique (Zdp) étant adjacente à un bord périphérique (Bp) de la face avant (Fav) d'une part, et entourant la zone centrale (Zc) d'autre part ;
- une couche mince résonante (13) en matériau piézoélectrique présentant une surface supérieure (s13sup) tournée vers le substrat initial (11) et une surface inférieure (s13inf) opposée à la surface supérieure (s13sup) ;
- une couche de liaison (15), interposée entre la zone centrale (Zc) du substrat initial (11), et la surface supérieure (s13sup) de la couche mince résonante (13) ; et
- des électrodes inférieures (12) en contact électrique avec la surface inférieure (s13inf) de la couche mince résonante (13)
• une étape de protection (E2), dans laquelle une couche mince de protection (17) est déposée sur l'empilement initial (10) du côté de la surface inférieure (s13inf) de la couche mince résonante (13), ladite couche mince de protection (17) recouvrant la zone de détourage périphérique (Zdp); la couche mince de protection (17) étant en un matériau présentant une impédance acoustique supérieure à 20 MRayl pour des ondes longitudinales et/ou supérieure à 12 MRayl pour des ondes de cisaillement, l'empilement primaire (30) étant formé à l'issue de l'étape de protection (E2) ;
- une étape de dépôt de couche de collage (E20), dans laquelle une couche de collage (20) est déposée du côté de la surface inférieure (s13inf) de la couche mince résonante (13) ;
- une étape de collage (E30), dans laquelle la face de réception (fr40) de l'empilement récepteur (40), et la couche de collage (20) sont mis en contact intime, de manière à solidariser l'empilement primaire (30) avec l'empilement récepteur (40) ;
- une phase de retrait (P40), dans laquelle le substrat initial (11) et la couche de liaison (15) sont retirés par voies mécaniques et chimiques; et
- une étape de définition d'électrodes (E50), dans laquelle des électrodes supérieures (14) sont déposées sur la surface supérieure (s13sup) de la couche mince résonante (13), puis définies par photolithographie, gravure et retrait de résine, de sorte que les électrodes supérieures (14) soient en contact électrique avec la couche mince résonante (13).

2. Procédé de fabrication (P2) selon la revendication 1, dans lequel lors de l'étape de protection (E2), la couche mince de protection (17) est déposée de sorte à recouvrir partiellement ou totalement la surface supérieure (s13sup) de la couche mince résonante (13), ainsi que la zone de détourage périphérique (Zdp).

3. Procédé de fabrication (P2) selon l'une quelconque des revendications 1 ou 2, dans lequel lors de l'étape de protection (E2), le matériau de la couche mince de protection (17) est choisi dans le groupe composé de AIN, Al₂O₃, HfN, HfO₂, SiₓN_{y}, Ta₂O₅, TiN, TaN, TiO₂, WO₃, ZnO, et ZrO₂.

4. Procédé de fabrication (P2) selon l'une quelconque des revendications 1 à 3, dans lequel lors de l'étape de fourniture (E1), la couche mince résonante (13) présente une épaisseur inférieure à 2 µm, et notamment inférieure à 1 µm.

5. Procédé de fabrication (P2) selon l'une quelconque des revendications 1 à 4, dans lequel l'étape de fourniture (E1) comprend :
- la fourniture (E01) d'un substrat donneur (1) comprenant une couche épaisse (3), le substrat donneur (1) présentant une face principale (fp3) du côté de la couche épaisse (3) ;
- l'implantation (E02) d'espèces légères dans la couche épaisse (3) pour y générer un plan de fragilisation (Pf3) et pour définir ainsi la couche mince résonnante (13) entre le plan de fragilisation (Pf3) et la face principale (fp3) du substrat donneur (1) ;
- la mise en contact (E03) de la face principale (fp3) du substrat donneur (1) avec la face avant (Fav) du substrat initial (11) ;
- le détachement (E04) de la couche mince résonante (13) au niveau du plan de fragilisation (Pf3), par l'application d'un traitement thermique.

6. Procédé de fabrication (P2) selon l'une quelconque des revendications 1 à 5, dans lequel lors de l'étape de protection (E2), la couche mince de protection (17) est en nitrure de silicium (SiN), et présente une épaisseur inférieure ou égale à 100 nm.

7. Procédé de fabrication (P2) selon l'une quelconque des revendications 1 à 5, dans lequel lors de l'étape de protection (E2), la couche mince de protection (17) est en nitrure d'aluminium (AIN), et présente une épaisseur inférieure ou égale à 50 nm.

8. Procédé de fabrication (P2) selon l'une quelconque des revendications 1 à 7, dans lequel lors de l'étape de mise à disposition (E10), l'empilement récepteur (40) comprend une couche d'isolant acoustique (43), ladite couche d'isolant acoustique (43) portant la face de réception (fr40) de l'empilement récepteur (40).

9. Procédé de fabrication (P2) selon la revendication 8, dans lequel la couche d'isolant acoustique (43) est un miroir de Bragg.

10. Procédé de fabrication (P2) selon l'une quelconque des revendications 1 à 9, dans lequel la phase de gravure (P40) comprend :
- une première étape de gravure (E41), dans laquelle le substrat initial (11) est retiré par meulage puis par gravure chimique anisotrope ; et
- une deuxième étape de gravure (E42), dans laquelle la couche de liaison (15) est retirée par gravure chimique à l'acide fluorhydrique.

11. Dispositif électronique (100) résonant obtenu par un procédé de fabrication (P2) selon l'une quelconque des revendications 1 à 10, le dispositif électronique (100) résonant comprenant l'empilement successif d'au moins :
- un empilement récepteur (40) ;
- une couche de collage (20) ;
- une couche mince de protection (17) comprenant un matériau isolant électrique ;
- des électrodes inférieures (12) en contact direct avec la couche mince de protection (17) ;
- une couche mince résonante (13) en matériau piézoélectrique présentant une surface supérieure (s13sup) et une surface inférieure (s13inf) opposées, la surface inférieure (s13inf) étant en contact électrique avec les électrodes inférieures (12) ;
- des électrodes supérieures (14) en contact électriques avec la surface supérieure (s13sup) de la couche mince résonante (13) ;
dispositif électronique (100) résonant dans lequel le matériau de la couche mince de protection (17) présente une impédance acoustique supérieure à 20 MRayl pour des ondes longitudinales et/ou supérieure à 12 MRayl pour des ondes de cisaillement.
